# EUROPEAN PATENT APPLICATION

(11) **EP 4 525 308 A1**
(43) Date of publication of application: **19.03.2025**
(21) Application number: 22941513.8
(22) Date of filing: 08.12.2022
(51) Int. Cl.: H03K 17/90

(54) **MAGNETIC SWITCH HAVING FILTERING FUNCTION**

(30) Priority: 12.05.2022 CN 202221155913 U
(71) Applicant: MultiDimension Technology Co., Ltd., Jiangsu 215634 (CN)
(72) Inventor: LI, Dongfeng, Zhangjiagang, Jiangsu 215634 (CN); LIN, Xiulong, Zhangjiagang, Jiangsu 215634 (CN); YAO, Gang, Zhangjiagang, Jiangsu 215634 (CN); YANG, Kai, Zhangjiagang, Jiangsu 215634 (CN)
(74) Representative: HGF
(86) International application number: PCT/CN2022/137479
(87) International publication number: WO 2023/216578

(57) **Abstract**

The present application discloses a magnetic switch having a filtering function. The magnetic switch comprises a magnetic sensing module and a specific integrated circuit. The specific integrated circuit comprises a power supply module, a comparison module, a filtering module and a logic operation module. An output end of the magnetic sensing module is electrically connected to an input end of the comparison module. The filtering module is electrically connected between an output end of the comparison module and an input end of the logic operation module. Or the filtering module is electrically connected between the output end of the magnetic sensing module and the input end of the logic operation module. The present application provides a highly integrated magnetic switch which has high frequency response, not only has the characteristics of a conventional magnetic switch, but also can set a switching frequency threshold by means of the filtering module, such that the highly integration magnetic switch can output high and low level change signals within a set switching frequency range. Therefore, the present application not only avoids the effect of invalid of the magnetic switch under the effect of a vibration or other environments, but also lower the power consumption and costs.

## Description

### TECHNICAL FIELD

The present application relates to the technical field of magnetic switches, and more specifically, to a magnetic switch having a filtering function.

### BACKGROUND TECHNOLOGY

Magnetic switches are widely used in fields such as position detection and speed detection. These switches function by monitoring the position and speed of a magnet attached to a moving object, thereby providing feedback on the object's position and speed status.

Conventional magnetic switches operate within a frequency response range of DC ~ 100KHz. In certain specialized fields, to prevent interference from vibration, false triggering, and other disruptive signals, it is necessary for magnetic switches to respond only within specific frequency ranges, such as 10Hz ~ 100Hz, DC ~ 3Hz, 100Hz ~ 100KHz, etc.

Currently, mainstream applications employ digital algorithms within MCUs to perform bandpass, low-pass, or high-pass filtering on the switch's output signals, which presents issues of high power consumption and elevated costs.

### SUMMARY OF THE INVENTION

The present application provides a magnetic switch having a filtering function to address the issue of high costs.

According to one aspect of the present application, a magnetic switch having a filtering function is provided, which comprises:
a magnetic sensing module, which is used to generate a magnetic field sensing signal based on variations in magnetic flux;
a specific integrated circuit electrically connected to the magnetic sensing module, which is used to receive the magnetic field sensing signal from the magnetic sensing module and generate high or low level switching signals based on that magnetic field sensing signal;
the specific integrated circuit comprising a power supply module, a comparison module, a filtering module, and a logic operation module;
the power supply module being electrically connected to the magnetic sensing module, the comparison module, the filtering module, and the logic operation module, respectively, for providing power to each of these modules;
the output end of the magnetic sensing module being electrically connected to the input end of the comparison module. The filtering module being electrically connected between the output end of the comparison module and the input end of the logic operation module; or the filtering module being electrically connected between the output end of the magnetic sensing module and the input end of the comparison module, and the output end of the comparison module being electrically connected to the input end of the logic operation module.

In the present application, a magnetic switch having a filtering function is proposed. The magnetic sensing module outputs a voltage signal based on the external magnetic field environment, while the specific integrated circuit performs a threshold comparison on the voltage signal and outputs a high or low level switching signal. The specific integrated circuit continuously monitors the frequency of the switching signal, only outputting switching signals with frequencies within the set threshold. When the switching frequency falls outside the set threshold, the output signal is locked at a high or low level. The present application provides a highly integrated magnetic switch featuring high frequency response. It not only has the characteristics of a conventional magnetic switch, but also can set a switching frequency threshold by means of the filtering module, such that the highly integration magnetic switch can output high- and low-level change signals within a set switching frequency range. Therefore, the present application not only avoids the effect of invalid of the magnetic switch under the effect of a vibration or other environments, but also lower the power consumption and costs.

It should be understood that the content described in this section is not intended to identify the key or important features of the embodiments of the present application, nor is it intended to limit the scope of the present application. Other features of the present application will become more readily apparent through the following description.

### DESCRIPTION OF THE DRAWINGS

In order to more clearly illustrate the technical solutions in the embodiments of the present application, the drawings required for use in the description of the embodiments will be briefly introduced below. Obviously, the drawings described below are merely some embodiments of the present application. Those skilled in the art may derive additional drawings based on these drawings, without any creative work.
FIG. 1 is a schematic diagram of a magnetic switch with filtering function provided in the embodiments of the present application;
FIG. 2 is a schematic diagram of another magnetic switch with filtering function provided in the embodiments of the present application;
FIG. 3 is a schematic diagram of yet another magnetic switch with filtering function provided in the embodiments of the present application;
FIG. 4 is a schematic diagram of another magnetic switch with filtering function provided in the embodiments of the present application;
FIG. 5 is a schematic diagram of yet another magnetic switch with filtering function provided in the embodiments of the present application;
FIG. 6 is a schematic diagram of another magnetic switch with filtering function provided in the embodiments of the present application;
FIG. 7 is a schematic diagram of a magnetic sensor;
FIG. 8 is a schematic diagram of another magnetic sensor;
FIG. 9 is a schematic diagram of yet another magnetic sensor.

### SPECIFIC IMPLEMENTATION METHODS

To facilitate a better understanding of the solutions presented in the present application by those skilled in the art, the following description will provide a clear and complete explanation of the technical solutions in the embodiments of the present application, in conjunction with the accompanying drawings. It is evident that the described embodiments are merely a part of the embodiments of the present application and do not encompass all embodiments. Based on the embodiments of the present application, all other embodiments that may be derived by those skilled in the art without making creative efforts should fall within the scope of protection of the present invention.

It should be noted that the terms "first," "second," and similar designations used in the description and claims, as well as in the accompanying drawings, are intended to distinguish similar objects and do not necessarily indicate a specific order or sequence. It is understood that such data can be interchanged where appropriate, allowing the embodiments of the present application described herein to be implemented in sequences other than those illustrated or described herein. Furthermore, the terms "comprising" and "having," along with any variations thereof, are intended to cover non-exclusive inclusions. For instance, a process, method, system, product, or device that comprises a series of steps or units is not limited to only those explicitly listed but may also include additional steps or units that are inherent to such processes, methods, products, or devices, even if not clearly specified.

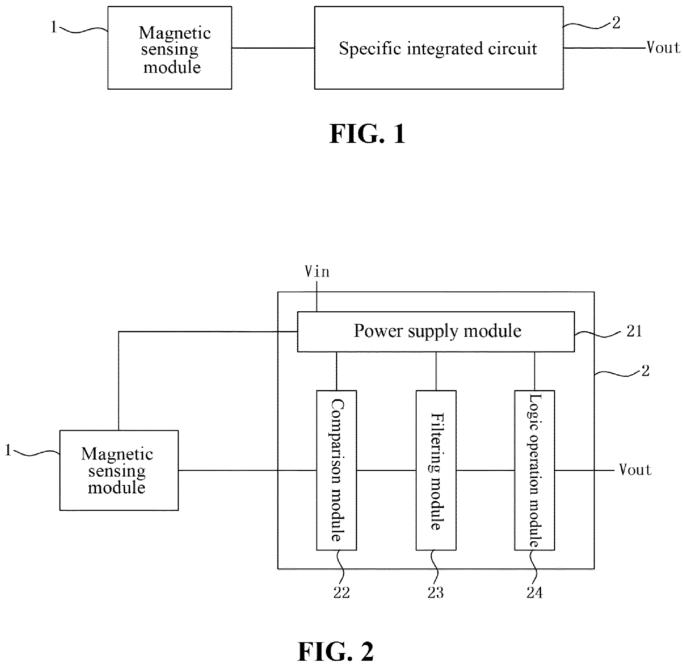

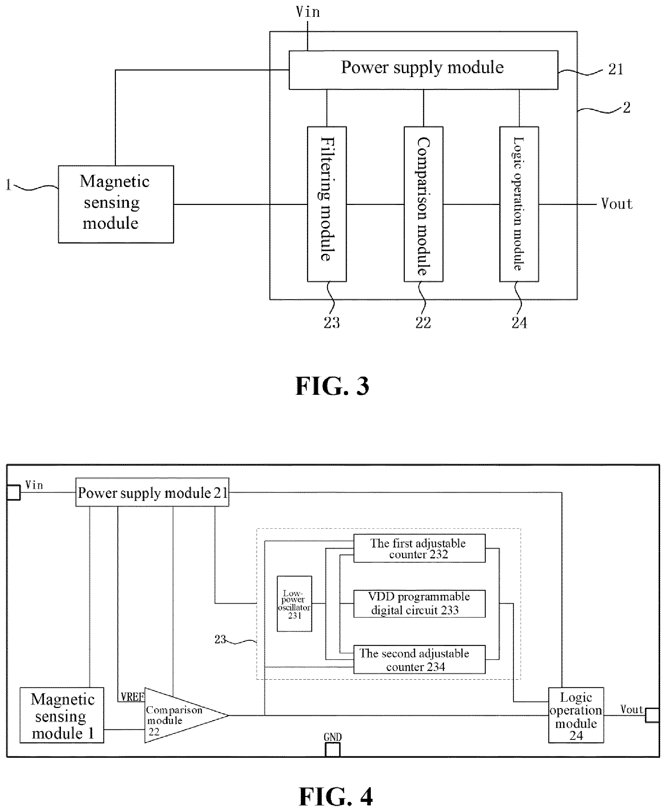

FIG. 1 is a schematic diagram of a magnetic switch with filtering function provided in the embodiments of the present application. FIG. 2 is a schematic diagram of another magnetic switch with filtering function provided in the embodiments of the present application. FIG. 3 is a schematic diagram of yet another magnetic switch with filtering function provided in the embodiments of the present application. As shown in FIGS. 1 to 3, the magnetic switch with filtering function comprises: a magnetic sensing module 1, which is used to generate a magnetic field sensing signal based on variations in magnetic flux; a specific integrated circuit 2, electrically connected to magnetic sensing module 1, which is used to receive the magnetic field sensing signal from magnetic sensing module 1 and generate high or low level switching signals based on that magnetic field sensing signal. The specific integrated circuit 2 comprises a power supply module 21, a comparison module 22, a filtering module 23, and a logic operation module 24. The power supply module 21 is electrically connected to the magnetic sensing module 1, comparison module 22, filtering module 23, and logic operation module 24 to provide power to each of these module. As shown in FIG. 2, the output end of magnetic sensing module 1 is electrically connected to the input end of the comparison module 22, and the filtering module 23 is electrically connected between the output end of the comparison module 22 and the input end of the logic operation module 24. Alternatively, as shown in FIG. 3, the filtering module 23 is electrically connected between the output end of the magnetic sensing module 1 and the input end of the comparison module 22, while the output end of the comparison module 22 is electrically connected to the input end of the logic operation module 24.

In this embodiment, the output end of the magnetic sensing module 1 is electrically connected to the input end of the specific integrated circuit 2. The magnetic sensing module 1 senses the magnetic field in its environment based on variations in magnetic flux and outputs the generated magnetic field sensing signal to the specific integrated circuit 2. The specific integrated circuit 2 is designed to receive the magnetic field sensing signal from the magnetic sensing module 1 and generate high or low level switching signals based on that magnetic field sensing signal. The output end of the specific integrated circuit 2 is the magnetic switch output end Vout, which is used to output the high or low level switching signal generated by the specific integrated circuit 2 in accordance with the magnetic field sensing signal.

The specific integrated circuit 2 comprises a power supply module 21, a comparison module 22, a filtering module 23 and a logic operation module 24. The specific integrated circuit 2 has a filtering function, specifically designed to receive the magnetic field sensing signal from the magnetic sensing module 1 and perform filtering, comparison, and logical operations, ultimately outputting a high or low level switching signal.

The power supply module 21 is electrically connected to the magnetic sensing module 1, comparison module 22, filtering module 23, and logic operation module 24, providing power to each of these modules. The optional power supply module 21 is a power circuit capable of independently supplying power to each module. It specifically receives the Vin signal provided by an external power source and converts it into multiple voltage signals required by the various modules, subsequently supplying these multiple voltage signals to each module, where the voltage requirements may be the same or different for each module. The magnetic sensing module 1 also features a power input end, which is electrically connected to the power supply module 21. The power supply module 21 powers the magnetic sensing module 1 through this power input end, and the output voltage signal from the magnetic sensing module 1 is directed to either the comparison module 22 or the filtering module 23 of the specific integrated circuit 2. The power supply module 21 not only supplies power to the comparison module 22 but also provides it with a reference voltage VREF for comparison purposes.

The filtering module 23 can be configured with a filtering frequency threshold. When the switching frequency received by the filtering module 23 falls within the set filtering frequency threshold, it outputs a high- or low-level changing signal. Conversely, when the switching frequency received by the filtering module 23 exceeds the set filtering frequency threshold, its output remains in a constant low or high level state.

The comparison module 22 includes a comparator, which is used to compare the input signals and output the comparison results. The logic operation module 24 is responsible for performing logical operations on the input signals and outputting the operation results.

As shown in FIG. 2, the output end of the magnetic sensing module 1 is electrically connected to the input end of the comparison module 22, and the filtering module 23 is electrically connected between the output end of the comparison module 22 and the input end of the logic operation module 24. The specific integrated circuit 2 is designed to receive the magnetic field sensing signal from the magnetic sensing module 1 and perform comparison, filtering, and logical operations, ultimately outputting a high or low level switching signal.

As shown in FIG. 3, the filtering module 23 is electrically connected between the output end of the magnetic sensing module 1 and the input end of the comparison module 22. The output end of the comparison module 22 is electrically connected to the input end of the logic operation module 24, and the output end of the logic operation module 24 is electrically connected to the magnetic switch output end Vout. The specific integrated circuit 2 is designed to receive the magnetic field sensing signal from the magnetic sensing module 1 and perform filtering, comparison, and logical operations, ultimately outputting a high or low level switching signal.

In the embodiments of the present application, a magnetic switch having a filtering function is proposed. The magnetic sensing module outputs a voltage signal based on the external magnetic field environment, while the specific integrated circuit performs a threshold comparison on the voltage signal and outputs a high or low level switching signal. The specific integrated circuit continuously monitors the frequency of the switching signal, only outputting switching signals with frequencies within the set threshold. When the switching frequency falls outside the set threshold, the output signal is locked at a high or low level. The highly integrated magnetic switch provided in the embodiments of the present application features a high frequency response. It not only has the characteristics of a conventional magnetic switch, but also can set a switching frequency threshold by means of the filtering module, such that the highly integration magnetic switch can output high- and low-level change signals within a set switching frequency range. Therefore, the present application not only avoids the effect of invalid of the magnetic switch under the effect of a vibration or other environments, but also lower the power consumption and costs.

FIG. 4 is a schematic diagram of yet another magnetic switch with filtering function provided in the embodiments of the present application. As shown in FIG. 4, the filtering module 23 is electrically connected between the output end of the comparison module 22 and the input end of the logic operation module 24. The filtering module 23 comprises a low-power oscillator 231, a first adjustable counter 232, a VDD programmable digital circuit 233, and a second adjustable counter 234. The low-power oscillator 231 is electrically connected to the first adjustable counter 232 and the second adjustable counter 234, respectively. The VDD programmable digital circuit 233 is electrically connected to the first adjustable counter 232 and the second adjustable counter 234, respectively, while the first adjustable counter 232 and the second adjustable counter 234 are electrically connected to the logic operation module 24, respectively.

In this embodiment, the filtering module 23 comprises a low-power oscillator 231, a first adjustable counter 232, a VDD programmable digital circuit 233, and a second adjustable counter 234. The low-power oscillator 231 is electrically connected to the first adjustable counter 232 and the second adjustable counter 234, respectively. The VDD programmable digital circuit 233 is electrically connected to the first adjustable counter 232 and the second adjustable counter 234, respectively. The output end of the comparison module 22 is electrically connected to the first adjustable counter 232 and the second adjustable counter 234, respectively, while the first adjustable counter 232 and the second adjustable counter 234 are electrically connected to the input end of the logic operation module 24, respectively. The output end of the comparison module 22 is also electrically connected to the logic operation module 24. The optional logic operation module 24 is an AND gate logic circuit.

When there is a periodic change in the external magnetic field, the magnetic sensing module 1 detects the variation in the magnetic field and transmits the resulting magnetic field sensing signal to the comparison module 22. The comparison module 22 processes this signal and outputs a high or low level corresponding to the periodic magnetic field changes. The output signals from the comparison module 22 are transmitted to the first adjustable counter 232 and the second adjustable counter 234, respectively.

The function of the adjustable counters is to count within the reset signal period of the oscillator. This count corresponds to the frequency of the high- or low-level signals output by the comparison module 22, specifically counting the occurrences of these signals. The VDD programmable digital circuit 233 is used to set the reference values for the adjustable counters to achieve a designated output frequency. Specifically, a set high value can be designated for the first adjustable counter 232, while a set low value can be designated for the second adjustable counter 234.

If the frequency of the high or low level signals output by the comparison module 22 exceeds the set high value, the first adjustable counter 232 will count a number greater than the set high value within one oscillator cycle, resulting in a low output signal from the first adjustable counter 232.

If the frequency of the high or low level signals output by the comparison module 22 is below the set low value, the second adjustable counter 234 will count a number less than the set low value within one oscillator cycle, leading to a low output signal from the second adjustable counter 234.

If the frequency of the high or low level signals output by the comparison module 22 falls within the range defined by the set low and high values, the first adjustable counter 232 will count a number below the set high value within one oscillator cycle, resulting in a high output signal from the first adjustable counter 232. Simultaneously, the second adjustable counter 234 will count a number above the set low value within one oscillator cycle, leading to a high output signal from the second adjustable counter 234.

As described above, when either the first adjustable counter 232 or the second adjustable counter 234 outputs a low signal, the logic operation module 24 sets the Vout terminal to a low level. When both the first adjustable counter 232 and the second adjustable counter 234 output high signals, the logic operation module 24 transmits the signal output from the comparison module 22 to the Vout terminal.

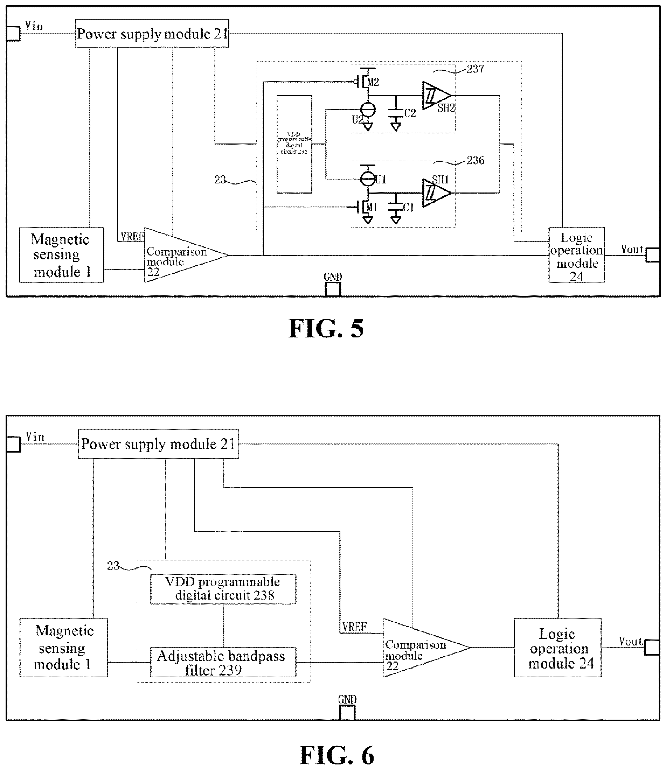

FIG. 5 is a schematic diagram of yet another magnetic switch with filtering function provided in the embodiments of the present application. As shown in FIG. 5, the filtering module 23 is electrically connected between the output end of the comparison module 22 and the input end of the logic operation module 24. The filtering module 23 includes a VDD programmable digital circuit 235, and a first filtering unit 236 and a second filtering unit 237 connected in parallel. The first filtering unit 236 comprises a first adjustable current source U1, an NMOS switch M1, a first Schmitt trigger SH1, and a first capacitor C1. The second filtering unit 237 includes a second adjustable current source U2, a PMOS switch M2, a second Schmitt trigger SH2, and a second capacitor C2. For either filtering unit, the adjustable current source is electrically connected between the VDD programmable digital circuit 235 and the MOS switch. The control end of the MOS switch is electrically connected to the comparison module, while the first end of the capacitor is connected between the adjustable current source and the MOS switch, and the second end of the capacitor is grounded. The input end of the Schmitt trigger is connected between the adjustable current source and the MOS switch, and the output end of the Schmitt trigger is connected to the logic operation module 24.

In this embodiment, the first filtering unit 236 comprises a first adjustable current source U1, an NMOS switch M1, a first Schmitt trigger SH1, and a first capacitor C1. The control end of the NMOS switch M1 is electrically connected to the output end of the comparison module 22. The first end of the NMOS switch M1 is grounded, while the second end is electrically connected to the first end of the first adjustable current source U1. The second end of the first adjustable current source U1 is electrically connected to the DC power supply, and the third end is electrically connected to the VDD programmable digital circuit 235. The first end of the first capacitor C1 is electrically connected to the second end of the NMOS switch M1, and the second end of the first capacitor C1 is grounded. The input end of the first Schmitt trigger SH1 is electrically connected to the second end of the NMOS switch M1, and the output end of the first Schmitt trigger SH1 is electrically connected to the input end of the logic operation module 24.

The second filtering unit 237 comprises the second adjustable current source U2, a PMOS switch M2, the second Schmitt trigger SH2, and the second capacitor C2. The control end of the PMOS switch M2 is electrically connected to the output end of the comparison module 22. The first end of the PMOS switch M2 is electrically connected to the DC power supply, while the second end is electrically connected to the first end of the second adjustable current source U2. The second end of the second adjustable current source U2 is grounded, and the third end is electrically connected to the VDD programmable digital circuit 235. The first end of the second capacitor C2 is electrically connected to the second end of the PMOS switch M2, and the second end of the second capacitor C2 is grounded. The input end of the second Schmitt trigger SH2 is electrically connected to the second end of the PMOS switch M2, and the output end of the second Schmitt trigger SH2 is electrically connected to the input end of the logic operation module 24.

The output end of the comparison module 22 is also electrically connected to the logic operation module 24. The optional logic operation module 24 is an AND gate logic circuit.

When there is a periodic change in the external magnetic field, the magnetic sensing module 1 detects the variation in the magnetic field and transmits the resulting magnetic field sensing signal to the comparison module 22. The comparison module 22 processes this signal and outputs a high or low level corresponding to the periodic magnetic field changes. The output signals from the comparison module 22 are transmitted to the control ends of the NMOS switch M1 and the PMOS switch M2, respectively. The function of NMOS switch M1 and PMOS switch M2 is to charge and discharge the subsequent load capacitor based on different switching frequencies. When the output signal from comparison module 22 is at a high level, NMOS switch M1 is turned on and PMOS switch M2 is turned off. Conversely, when the output signal from comparison module 22 is at a low level, NMOS switch M1 is turned off and PMOS switch M2 is turned on.

The first adjustable current source U1 and the second adjustable current source U2 serve as active loads for the load capacitor. The VDD programmable digital circuit 235 is used to set the reference values for the adjustable current sources to achieve a designated output frequency. Specifically, a set high value can be designated for the first filtering unit 236, while a set low value can be designated for the second filtering unit 237.

If the frequency of the high- or low-level signals output by the comparison module 22 exceeds the set high value, the current through NMOS switch M1 will be greater than the current through the second adjustable current source U2, resulting in the second Schmitt trigger SH2 outputting a low signal.

If the frequency of the high- or low-level signals output by the comparison module 22 falls below the set low value, the current through PMOS switch M2 will be less than the current through the first adjustable current source U1, causing the first Schmitt trigger SH1 to output a low signal.

If the frequency of the high- or low-level signals output by the comparison module 22 falls within the range defined by the set low and high values, both the first Schmitt trigger SH1 and the second Schmitt trigger SH2 will output high signals.

As described above, when either the first Schmitt trigger SH1 or the second Schmitt trigger SH2 outputs a low signal, the logic operation module 24 will set the Vout terminal to a low level. When both the first Schmitt trigger SH1 and the second Schmitt trigger SH2 output high signals, the logic operation module 24 transmits the signal output from the comparison module 22 to the Vout terminal.

FIG. 6 is a schematic diagram of yet another magnetic switch with filtering function provided in the embodiments of the present application. As shown in FIG. 6, the filtering module 23 is electrically connected between the output end of the magnetic sensing module 1 and the input end of the comparison module 22. The filtering module 23 comprises an electrically connected VDD programmable digital circuit 238 and an adjustable bandpass filter 239, with the output end of the adjustable bandpass filter 239 electrically connected to the comparison module 22.

In this embodiment, the filtering module 23 includes an electrically connected VDD programmable digital circuit 238 and an adjustable bandpass filter 239. The input end of the adjustable bandpass filter 239 is connected to the output end of the magnetic sensing module 1, while the output end of the adjustable bandpass filter 239 is electrically connected to the input end of the comparison module 22. The output end of the comparison module 22 is also electrically connected to the input end of the logic operation module 24.

When there is a periodic change in the external magnetic field, the magnetic sensing module 1 detects the variations in the magnetic field and transmits the sensed magnetic field signal to the adjustable bandpass filter 239 of the filtering module 23. The VDD programmable digital circuit 238 is used to set the frequency range of the adjustable bandpass filter 239, enabling the functionality of setting low-pass, high-pass, or bandpass frequencies. Specifically, a set high value can be designated for the first filtering unit 236, while a set low value can be designated for the second filtering unit 237.

If the magnetic field sensing signal output by the magnetic sensing module 1 falls within the frequency range of the adjustable bandpass filter 239, the magnetic field sensing signal will not be attenuated as it passes through the adjustable bandpass filter 239, allowing it to effectively trigger the comparison module 22, which will then toggle.

If the magnetic field sensing signal output by the magnetic sensing module 1 is outside the frequency range of the adjustable bandpass filter 239, the magnetic field sensing signal will be attenuated upon passing through the adjustable bandpass filter 239, rendering the attenuated magnetic field sensing signal incapable of triggering the comparison module 22, which will not toggle.

As described above, when the comparison module 22 outputs a low signal, the logic operation module 24 sets the Vout terminal to a low level. When the comparison module 22 outputs a high signal, the logic operation module 24 transmits the signal output from the comparison module 22 to the Vout terminal.

In any of the aforementioned embodiments, the number of optional filtering modules is at least one, with this at least one filtering module being used to perform filtering operations over at least one range.

The optional magnetic sensing module comprises at least one magnetic sensor. The optional magnetic sensors are Hall sensors, anisotropic magnetoresistive sensors, giant magnetoresistive sensors, or tunnel magnetoresistive sensors. Without limitation, any magnetic sensor suitable for the magnetic switch in the embodiments of the present application falls within the scope of protection of the present application, and there is no restriction on the number of magnetic sensors in the magnetic sensing module.

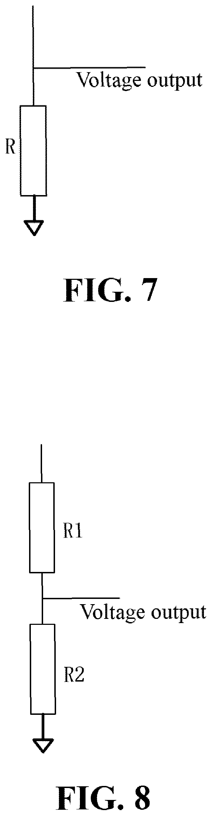

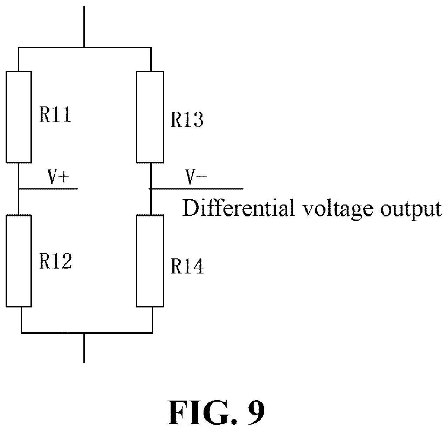

The circuit structure of at least one optional magnetic sensor is of a single-resistor, half-bridge, or full-bridge configuration. FIG. 7 is a schematic diagram of a magnetic sensor. As shown in FIG. 7, this magnetic sensor comprises a single resistor R, configured in a single resistor structure, with its voltage output end delivering a magnetic field sensing signal. FIG. 8 is a schematic diagram of another magnetic sensor. As shown in FIG. 8, this sensor includes two resistors R1 and R2, arranged in a half-bridge configuration, with its voltage output end providing a magnetic field sensing signal. FIG. 9 is a schematic diagram of yet another magnetic sensor. As shown in FIG. 9, this magnetic sensor consists of four resistors R11 to R14, configured in a full-bridge structure, with its two voltage output ends V+ and V- delivering a differential signal that represents the magnetic field sensing signal.

It should be understood that various forms of the processes illustrated above can be utilized, with the ability to reorder, add, or remove steps. For example, the various modules described in the present application may be executed in parallel, sequentially, or in a different order, as long as they achieve the desired results of the technical solution presented in the present application; no restrictions are placed on this matter herein.

The specific embodiments described above do not constitute limitations on the scope of protection of the present application. Those skilled in the art should understand that various modifications, combinations, sub-combinations, and alternatives can be made based on design requirements and other factors. Any modifications, equivalent substitutions, and improvements made within the spirit and principles of the present application shall be included within the scope of protection of the present application.

## Claims

1. A magnetic switch having a filtering function, **characterized by** comprising:
a magnetic sensing module, which is used to generate a magnetic field sensing signal based on variations in magnetic flux;
a specific integrated circuit electrically connected to the magnetic sensing module, which is used to receive the magnetic field sensing signal from the magnetic sensing module and generate high or low level switching signals based on that magnetic field sensing signal;
the specific integrated circuit comprising a power supply module, a comparison module, a filtering module, and a logic operation module;
the power supply module being electrically connected to the magnetic sensing module, the comparison module, the filtering module, and the logic operation module, respectively, for providing power to each of these modules;
the output end of the magnetic sensing module being electrically connected to the input end of the comparison module, the filtering module being electrically connected between the output end of the comparison module and the input end of the logic operation module; or the filtering module being electrically connected between the output end of the magnetic sensing module and the input end of the comparison module, and the output end of the comparison module being electrically connected to the input end of the logic operation module.

2. The magnetic switch having a filtering function according to claim 1, **characterized in that** the filtering module is electrically connected between the output end of the comparison module and the input end of the logic operation module;
the filtering module includes a low-power oscillator, a first adjustable counter, a VDD programmable digital circuit, and a second adjustable counter, the low-power oscillator is electrically connected to the first adjustable counter and the second adjustable counter, respectively, the VDD programmable digital circuit is electrically connected to the first adjustable counter and the second adjustable counter, respectively, and the first adjustable counter and the second adjustable counter are electrically connected to the logic operation module, respectively.

3. The magnetic switch having a filtering function according to claim 1, **characterized in that** the filtering module is electrically connected between the output end of the comparison module and the input end of the logic operation module;
the filtering module includes a VDD programmable digital circuit and a first and a second filtering unit connected in parallel, the first filtering unit comprises a first adjustable current source, an NMOS switch, a first Schmitt trigger, and a first capacitor, while the second filtering unit comprises a second adjustable current source, a PMOS switch, a second Schmitt trigger, and a second capacitor;
for either filtering unit, the adjustable current source is electrically connected between the VDD programmable digital circuit and the MOS switch, the control end of the MOS switch is electrically connected to the comparison module, while the first end of the capacitor is connected between the adjustable current source and the MOS switch, and the second end of the capacitor is grounded; the input end of the Schmitt trigger is connected between the adjustable current source and the MOS switch, and the output end of the Schmitt trigger is electrically connected to the logic operation module.

4. The magnetic switch having a filtering function according to claim 1, **characterized in that** the filtering module is electrically connected between the output end of the magnetic sensing module and the input end of the comparison module;
the filtering module includes a VDD programmable digital circuit and an adjustable bandpass filter that are electrically connected, and the input end of the adjustable bandpass filter is electrically connected to the comparison module.

5. The magnetic switch having a filtering function according to claim 1, **characterized in that** the number of the filtering modules is at least one, with this at least one filtering module being used to perform filtering operations over at least one range.

6. The magnetic switch having a filtering function according to claim 1, **characterized in that** the magnetic sensing module comprises at least one magnetic sensor.

7. The magnetic switch having a filtering function according to claim 6, **characterized in that** the magnetic sensor is a Hall sensor, an anisotropic magnetoresistive sensor, a giant magnetoresistive sensor, or a tunnel magnetoresistive sensor.

8. The magnetic switch having a filtering function according to claim 6, **characterized in that** the circuit structure of the at least one magnetic sensor is of a single-resistor, half-bridge, or full-bridge configuration.
